(19) 

Europäisches
Patentamt
European
Patent Office
Office européen
des brevets

(11) **EP 4 489 041 A1**

(12) **EUROPEAN PATENT APPLICATION**
published in accordance with Art. 153(4) EPC

(43) Date of publication:
**08.01.2025 Bulletin 2025/02**

(21) Application number: **23763175.9**

(22) Date of filing: **03.02.2023**

(51) International Patent Classification (IPC):
**H01F 30/10** (2006.01)   **H01F 27/24** (2006.01)
**H01F 27/28** (2006.01)   **H01F 27/34** (2006.01)

(52) Cooperative Patent Classification (CPC):
**H01F 27/24; H01F 27/28; H01F 27/34; H01F 30/10**

(86) International application number:
**PCT/JP2023/003603**

(87) International publication number:
**WO 2023/166913 (07.09.2023 Gazette 2023/36)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **04.03.2022 JP 2022033794**

(71) Applicant: **Omron Corporation
Kyoto-shi, Kyoto 600-8530 (JP)**

(72) Inventors:
• **ISHIBASHI, Hiroki
Kyoto-shi, Kyoto 600-8530 (JP)**
• **IMADA, Koji
Kyoto-shi, Kyoto 600-8530 (JP)**
• **EBISUMOTO, Daigoro
Kyoto-shi, Kyoto 600-8530 (JP)**

(74) Representative: **HGF
HGF Limited
1 City Walk
Leeds LS11 9DX (GB)**

(54) **TRANSFORMER AND NOISE FILTER DEVICE**

(57)     A transformer includes an iron core including an iron core main body, a first main winding wire, a second main winding wire, a first detection winding wire, and a second detection winding wire. The iron core main body includes a first through hole, a second through hole, and a first leg portion positioned between the first through hole and the second through hole, the first through hole and the second through hole being positioned at intervals in a first direction. The first main winding wire is wound around the first leg portion and includes winding ends positioned in the first through hole. The second main winding wire is wound around the first leg portion and includes winding ends positioned in the second through hole. The first detection winding wire is wound around the iron core in a state where a magnetic flux generated by a common mode noise is cancelable and configured to detect a normal mode noise current. The second detection winding wire is wound around the iron core in a state where a magnetic flux generated by the normal mode noise current is cancelable and configured to detect the common mode noise current.

Fig. 2

## Description

TECHNICAL FIELD

The present disclosure relates to a transformer and a noise filter device.

BACKGROUND ART

Patent Document 1 discloses a transformer including a tubular bobbin and a coil wound along an outer periphery and an axis of the bobbin.

CITATION LIST

PATENT DOCUMENT

Patent Document 1: JP-A-2022-018792

SUMMARY OF THE INVENTION

PROBLEMS TO BE SOLVED BY THE INVENTION

In general, a noise current detection transformer for an active filter can detect only one of a common mode noise current and a normal mode noise current. Therefore, two transformers are required when both the common mode noise current and the normal mode noise current are reduced, and the power supply circuit may be increased in size.

An object of the present disclosure is to provide a transformer capable of downsizing a power supply circuit, and a noise filter device including the transformer.

SOLUTIONS TO THE PROBLEMS

A transformer according to one aspect of the present disclosure includes:

an iron core including an iron core main body including a first through hole, a second through hole, and a first leg portion, the first through hole and the second through hole being positioned at intervals in a first direction and each penetrating the iron core main body in a second direction that intersects the first direction, the first leg portion being positioned between the first through hole and the second through hole;

a first main winding wire wound around the first leg portion and including winding ends positioned in the first through hole;

a second main winding wire wound around the first leg portion and including winding ends positioned in the second through hole;

a first detection winding wire wound around the iron core in a state where a magnetic flux generated by a common mode noise current flowing through the first main winding wire and the second main winding wire is cancelable, the first detection winding wire being configured to detect a normal mode noise current flowing through the first main winding wire and the second main winding wire; and

a second detection winding wire wound around the iron core in a state where a magnetic flux generated by the normal mode noise current is cancelable, the second detection winding wire being configured to detect the common mode noise current.

A noise filter device according to one aspect of the present disclosure includes the transformer according to the above aspect.

EFFECTS OF THE INVENTION

According to the transformer of the above aspect, it is possible to realize a transformer capable of downsizing a power supply circuit.

According to the noise filter device of the above aspect, it is possible, by the noise filter device, to realize a noise filter device capable of downsizing the power supply circuit.

BRIEF DESCRIPTION OF THE DRAWINGS

Fig. 1 is a schematic block diagram illustrating a noise filter device including a transformer according to an embodiment of the present disclosure.
Fig. 2 is a perspective view of the transformer of Fig. 1.
Fig. 3 is a front view of the transformer of Fig. 1.
Fig. 4 is a schematic front view of the transformer of Fig. 1.
Fig. 5 is a first sectional view taken along line V-V of Fig. 4 for explaining how to wind a first detection winding wire.
Fig. 6 is a first sectional view taken along line V-V of Fig. 4 for explaining how to wind a second detection winding wire.
Fig. 7 is a second sectional view taken along line V-V of Fig. 4 for explaining how to wind the second detection winding wire.
Fig. 8 is a third sectional view taken along line V-V of Fig. 4 for explaining how to wind the second detection winding wire.
Fig. 9 is a perspective view illustrating a first modified example of the transformer of Fig. 1.
Fig. 10 is a front view illustrating a second modified example of the transformer of Fig. 1.
Fig. 11 is a front view illustrating a third modified example of the transformer of Fig. 1.
Fig. 12 is a perspective view illustrating a fourth modified example of the transformer of Fig. 1.
Fig. 13 is a plan view illustrating a state in which a part of an iron core main body of the transformer of Fig. 12 is removed.

Fig. 14 is a second sectional view taken along line V-V of Fig. 4 for explaining how to wind the first detection winding wire.

Fig. 15 is a fourth sectional view taken along line V-V of Fig. 4 for explaining how to wind the second detection winding wire.

Fig. 16 is a schematic front view for explaining how to wind the first detection winding wire and the second detection winding wire.

DETAILED DESCRIPTION

Hereinafter, one example of the present disclosure will be described with reference to the accompanying drawings. The following description is merely exemplary in nature and is not intended to limit the present disclosure, its application, or its use. The accompanying drawings are schematic, and ratios of dimensions and the like do not necessarily match actual ones.

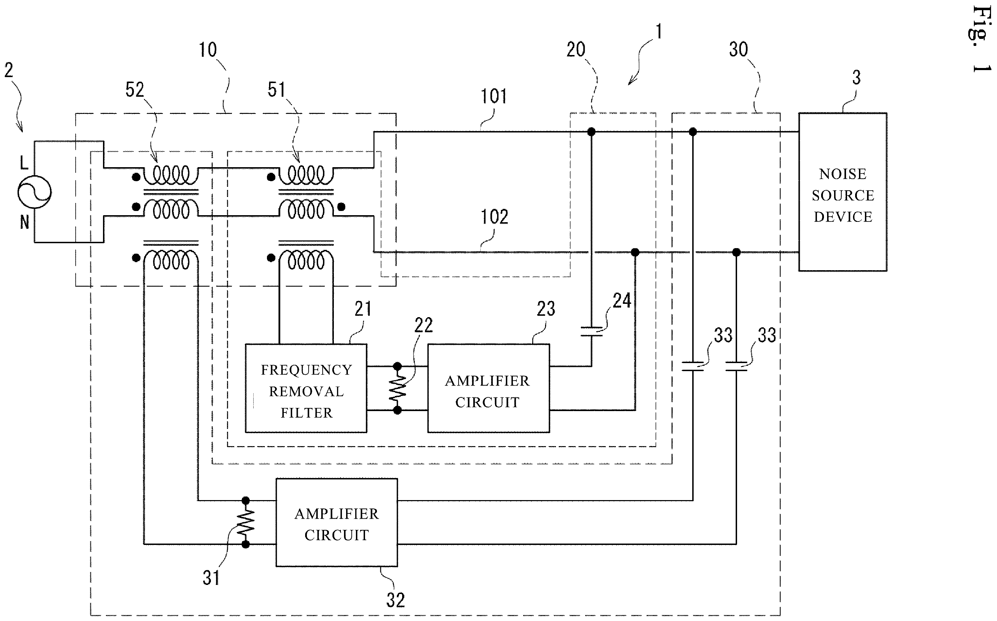

As illustrated in Fig. 1, a transformer 10 according to an embodiment of the present disclosure constitutes a part of a noise filter device 1 (It is also referred to as active filter). In the present embodiment, the noise filter device 1 is inserted into conductive lines 101 and 102 connecting an AC power source 2 and a noise source device 3. The noise filter device 1 includes a normal mode active filter 20 and a common mode active filter 30.

At least one of the AC power source 2 and the noise source device 3 includes a circuit including an active element. The active elements can generate a noise signal. For example, when the noise source device 3 includes a power factor corrector circuit and a DC/DC converter, or includes a rectifier and an inverter, at least one of the power factor corrector circuit and the DC/DC converter, or at least one of the rectifier and the inverter includes a circuit including an active element. The generated noise signal propagates through the conductive lines 101 and 102 as a normal mode noise signal or a common mode noise signal.

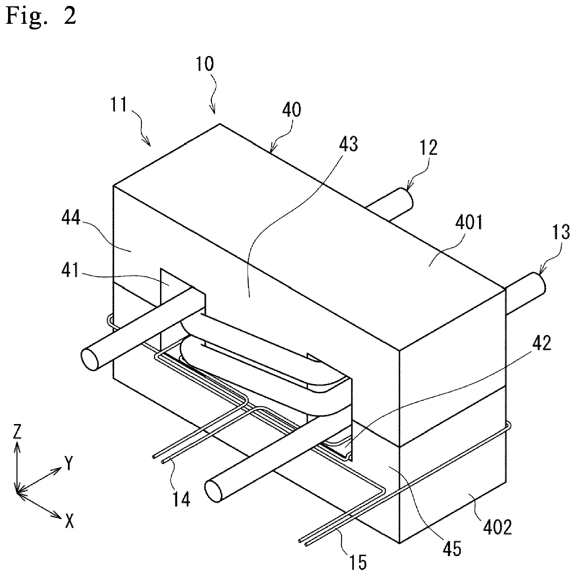

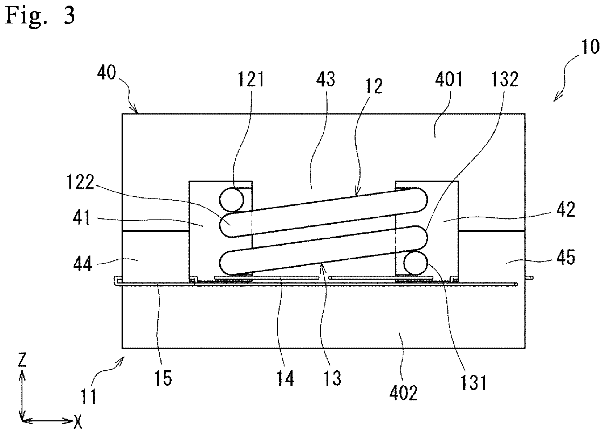

As illustrated in Figs. 2 and 3, the transformer 10 includes an iron core 11, a first main winding wire 12, a second main winding wire 13, a first detection winding wire 14, and a second detection winding wire 15. The iron core 11, the first main winding wire 12, the second main winding wire 13, the first detection winding wire 14, and the second detection winding wire 15 are insulated from each other. The insulation between the iron core 11 and each of the winding wires may be realized, for example, by covering each winding wire with an insulating film, or by covering the iron core 11 with an insulating bobbin or the like. The standard of each winding wire is set according to the design, application, and the like of the transformer 10.

As an example, the iron core 11 includes an iron core main body 40 having a substantially rectangular parallelepiped shape. The iron core main body 40 includes a first through hole 41 and a second through hole 42 positioned at intervals in a first direction (for example, X direction), and a first leg portion 43 positioned between the first through hole 41 and the second through hole 42. The first through hole 41 and the second through hole 42 each penetrate the iron core main body 40 in a second direction (for example, Y direction) intersecting the first direction X.

In the present embodiment, the iron core main body 40 includes two magnetic members 401 and 402. Each of the members 401 and 402 has a substantially E-shape when viewed along the second direction Y, and includes a second leg portion 44 and a third leg portion 45 in addition to the first leg portion 43. The second leg portion 44 is positioned on one side of the first leg portion 43 in the first direction X, and the first through hole 41 is positioned between the second leg portion and the first leg portion 43. The third leg portion 45 is positioned on the other (another) side of the first leg portion 43 in the first direction X, and the second through hole 42 is positioned between the third leg portion and the first leg portion 43.

The first main winding wire 12 is wound around the first leg portion 43, and winding ends 121 and 122 are positioned in the first through hole 41. In other words, the first main winding wire 12 is wound around the first leg portion 43 so as to start winding from the first through hole 41 and finish winding at the first through hole 41.

The second main winding wire 13 is wound around the first leg portion 43, and winding ends 131 and 132 are positioned in the second through hole 42. In other words, the second main winding wire 13 is wound around the first leg portion 43 so as to start winding from the second through hole 42 and finish winding at the second through hole 42.

Each of the first main winding wire 12 and the second main winding wire 13 is wound around the first leg portion 43 by N.5 turns (N is a natural number). In the present exemplary embodiment, each of the first main winding wire 12 and the second main winding wire 13 is wound around the first leg portion 43 by 1.5 turns.

The first detection winding wire 14 is wound around the iron core 11 in a state in which the magnetic flux generated by a common mode noise current flowing through the first main winding wire 12 and the second main winding wire 13 is cancelable. The first detection winding wire 14 is configured to detect a normal mode noise current flowing through the first main winding wire 12 and the second main winding wire 13. Hereinafter, the iron core 11, the first main winding wire 12, the second main winding wire 13, and the first detection winding wire 14 are referred to as a normal mode noise current detection unit 51.

The second detection winding wire 15 is wound around the iron core 11 in a state in which the magnetic flux generated by the normal mode noise current flowing through the first main winding wire 12 and the second main winding wire 13 is cancelable. The second detection winding wire 15 is configured to detect the common mode noise current flowing through the first main winding wire 12 and the second main winding wire 13. Hereinafter, the iron core 11, the first main winding wire 12, the second main winding wire 13, and the second detection winding wire 15 are referred to as a common mode noise current detection unit 52.

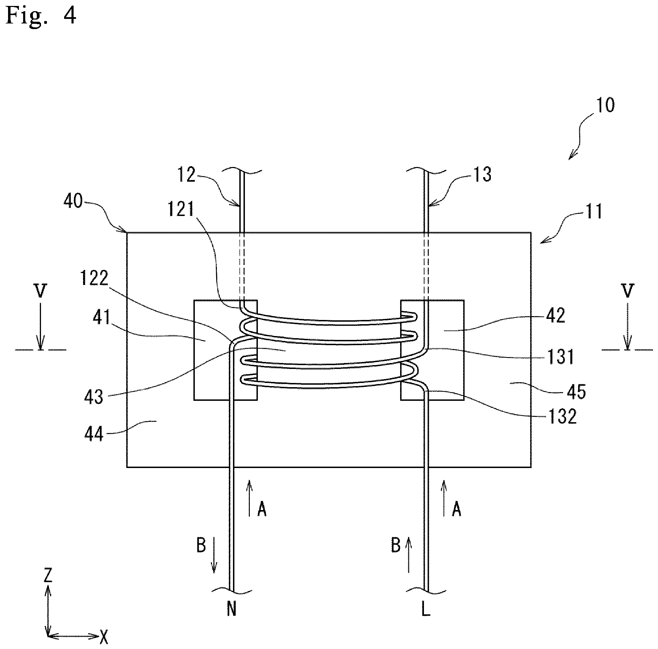

Fig. 4 illustrates transformer 10 in which each of the first main winding wire 12 and the second main winding wire 13 is wound around the first leg portion 43 by 2.5 turns. In Fig. 4, an arrow A indicates a direction in which the common mode noise current flows through the first main winding wire 12 and the second main winding wire 13, and an arrow B indicates a direction in which the normal mode noise current flows through the first main winding wire 12 and the second main winding wire 13.

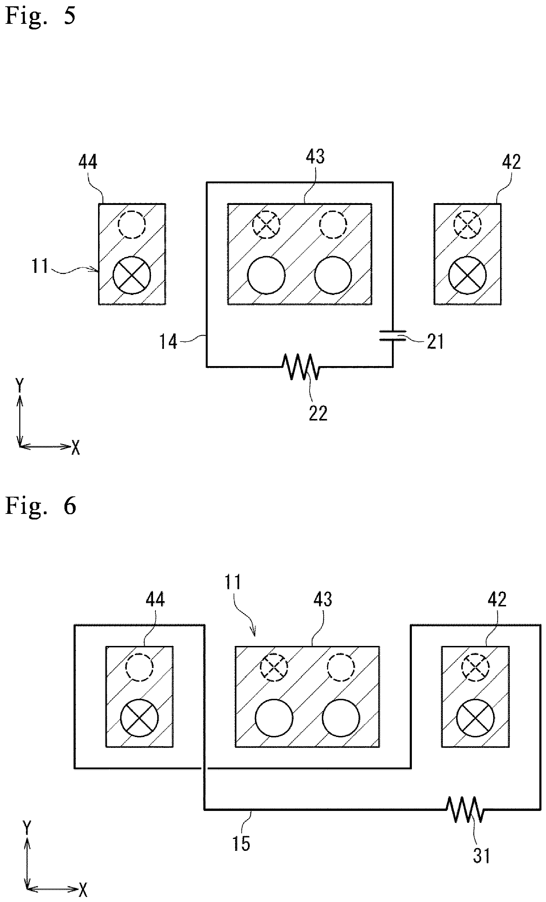

Fig. 5 illustrates an example of a winding method of the first detection winding wire 14, and Fig. 6 illustrates an example of a winding method of the second detection winding wire 15. In Figs. 5 and 6, a direction of the magnetic flux due to the normal mode noise current is indicated by a solid line, and a direction of the magnetic flux due to the common mode noise current is indicated by a dotted line.

An absolute value of a voltage $V_{NM}$ detected by the first detection winding wire 14 is calculated by, for example, the following Formula 1. In the following Formula 1, n1 is the total number of turns (=2 × N.5 turns) of the first main winding wire 12 and the second main winding wire 13 with respect to the first leg portion 43, $n_{NM}$ is the number of turns of the first detection winding wire 14 with respect to the iron core 11, $i_{NM1}$ is a current value of the normal mode noise current flowing through the first main winding wire 12 and the second main winding wire 13, and $R_{NM}$ is a resistance value of a detection resistor 22 connected to the first detection winding wire 14. In Fig. 5, $n_{NM}=1$, for example,

[Formula 1]

$$|V_{NM}| = \frac{n_1}{n_{NM}} i_{NM1} R_{NM}$$

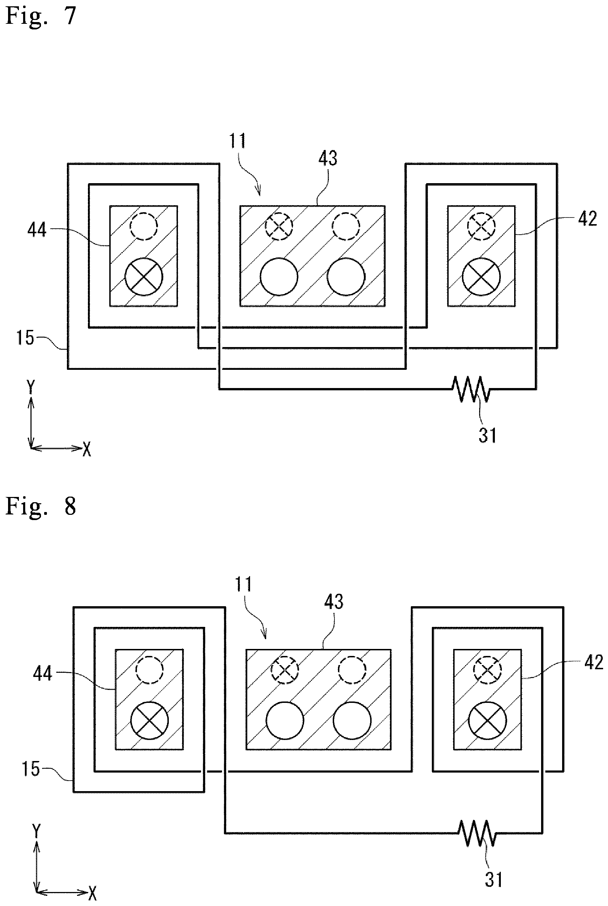

An absolute value of a voltage $V_{CM}$ detected by the second detection winding wire 15 is calculated by, for example, the following Formula 2. In the following Formula 2, $n_{CM}$ is the number of turns of the second detection winding wire 15 with respect to the iron core 11, $i_{CM1}$ is a current value of the common mode noise current flowing through the first main winding wire 12 and the second main winding wire 13, and $R_{CM}$ is a resistance value of a detection resistor 31 connected to the second detection winding wire 15. In Fig. 6, $n_{CM}=1$, for example. An example of how to wind the second detection winding wire 15 when $n_{CM}=2$ is illustrated in Figs. 7 and 8.

[Formula 2]

$$|V_{CM}| = \frac{1}{n_{CM}} i_{CM1} R_{CM}$$

The normal mode active filter 20 generates an inverted signal having a polarity opposite to a polarity of the normal mode noise signal flowing through the conductive lines 101 and 102. As an example, as illustrated in Fig. 1, the normal mode active filter 20 includes the normal mode noise current detection unit 51 of the transformer 10, a frequency removal filter 21, the detection resistor 22, an amplifier circuit 23, and a capacitor 24. The first detection winding wire 14 of the transformer 10 is connected to the frequency removal filter 21. The frequency removal filter 21 includes at least one filter circuit. The detection resistor 22 is positioned between the frequency removal filter 21 and the amplifier circuit 23. The amplifier circuit 23 includes, for example, an active element such as an operational amplifier. The capacitor 24 is positioned between the amplifier circuit 23 and the conductive line 101 or between the amplifier circuit 23 and the conductive line 102.

The common mode active filter 30 generates an inverted signal having a polarity opposite to a polarity of the common mode noise signal flowing through the conductive lines 101 and 102. As an example, as illustrated in Fig. 1, the common mode active filter 30 includes the common mode noise current detection unit 52 of the transformer 10, the detection resistor 31, an amplifier circuit 32, and two capacitors 33. The second detection winding wire 15 of the transformer 10 is connected to the amplifier circuit 32. The detection resistor 31 is positioned between the second detection winding wire 15 and the amplifier circuit 32. The amplifier circuit 32 includes, for example, an active element such as an operational amplifier. Each capacitor 33 is positioned respectively between the amplifier circuit 23 and the conductive line 101 and between the amplifier circuit 32 and the conductive line 102.

The transformer 10 and the noise filter device 1 can exhibit the following effects.

The transformer 10 includes the iron core 11, the first main winding wire 12, the second main winding wire 13, the first detection winding wire 14, and the second detection winding wire 15. The iron core 11 includes the iron core main body 40. The iron core main body 40 includes the first through hole 41, the second through hole 42, and the first leg portion 43, the first through hole 41 and the second through hole 42 being positioned at intervals in the first direction and penetrating the iron core main body 40 in the second direction, the first leg portion 43 being positioned between the first through hole 41 and the second through hole 42. The first main winding wire 12 is wound around the first leg portion 43, and the winding ends 121 and 122 are positioned in the first through hole 41. The second main winding wire 13 is wound around the first leg portion 43, and the winding ends 131 and 132 are positioned in the second through hole 42. The first detection winding wire 14 is wound around the iron core 11 in a state in which the magnetic flux generated by the common mode noise current flowing through the first main winding wire 12 and the second main winding wire 13 is cancelable. The first detection winding wire 14 is configured to detect the normal mode noise current flowing through the first main winding wire 12 and the second main winding wire 13. The second detection winding wire 15 is wound around the iron core 11 in a state in which the magnetic flux generated by the normal mode noise current flowing through the first main winding wire 12 and the second main winding wire 13 is cancelable. The second detection winding wire 15 is configured to detect the common mode noise current flowing through the first main winding wire 12 and the second main winding wire 13. With such a configuration, it is possible to detect both the normal mode noise current and the common mode noise current, and therefore it is not necessary to provide a plurality of transformers even when both the normal mode noise current and the common mode noise current are required to be detected. As a result, the transformer 10 capable of downsizing the power supply circuit can be realized.

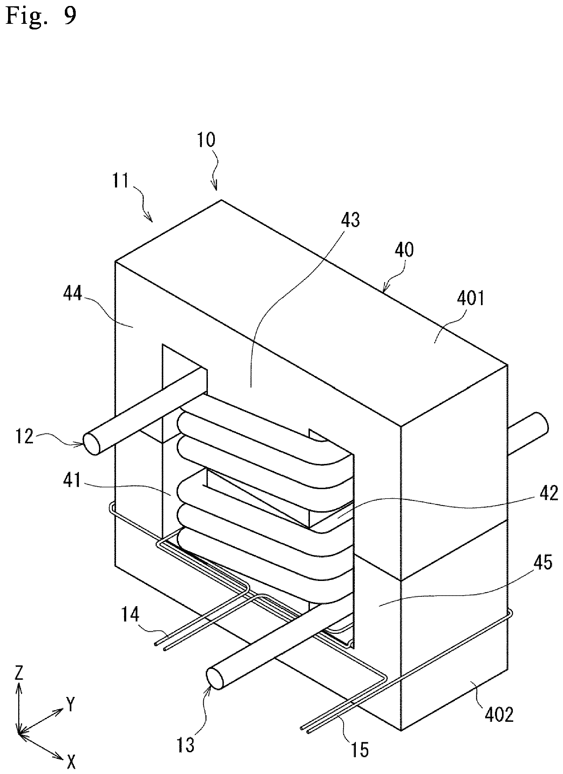

As illustrated in Fig. 9, by increasing the numbers of turns of the first main winding wire 12 and the second main winding wire 13 with respect to the first leg portion 43, inductance with respect to the normal mode noise current increases, and a function as a normal mode choke that filters the normal mode noise current is provided. The first detection winding wire 14 and the second detection winding wire 15 are adjusted to obtain desired detection gains as the numbers of turns of the first main winding wire 12 and the second main winding wire 13 increase. In Fig. 9, each of the first main winding wire 12 and the second main winding wire 13 is wound around the first leg portion 43 by 3.5 turns.

The noise filter device 1 can reduce both the normal mode noise current and the common mode noise current by the transformer 10. As a result, the noise filter device capable of downsizing the power supply circuit can be realized.

The transformer 10 may be configured as follows.

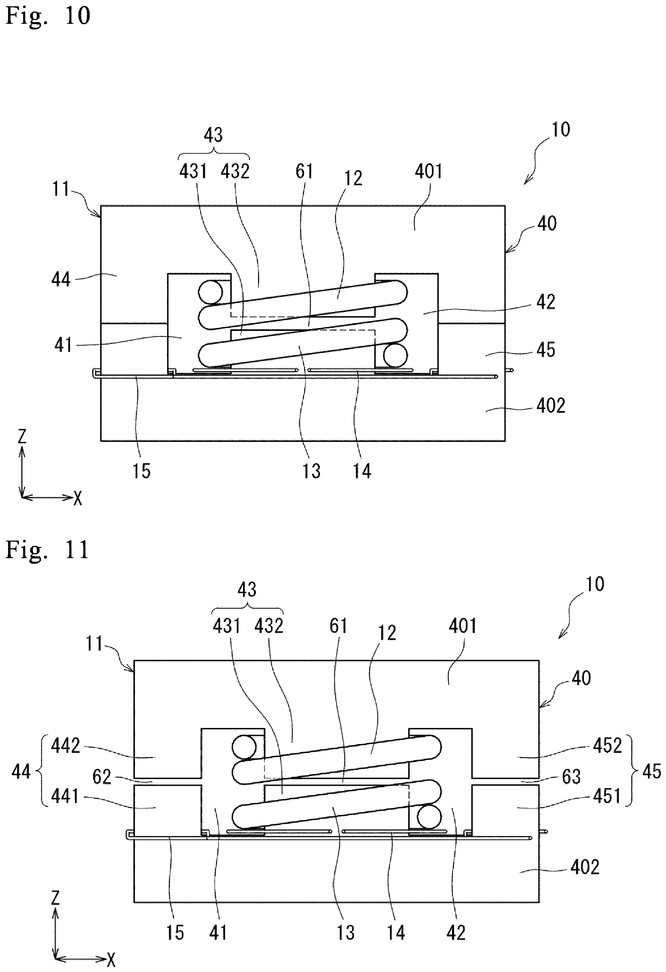

As illustrated in Fig. 10, the first leg portion 43 may have a gap 61 in a third direction (for example, Z direction) that intersects the first direction X and the second direction Y As illustrated in Fig. 11, the second leg portion 44 may have a gap 62 in the third direction Z, and the third leg portion 45 may have a gap 63 in the third direction Z. With this configuration, it is possible to adjust inductance with respect to the normal mode noise current or the common mode noise current while magnetic saturation is prevented. In Fig. 10, the first leg portion 43 includes a pair of first barrel portions 431 and 432 positioned with the gap 61 therebetween. In Fig. 11, the second leg portion 44 includes a pair of second barrel portions 441 and 442 positioned in the third direction Z with the gap 62 therebetween, and the third leg portion 45 includes a pair of third barrel portions 451 and 452 positioned in the third direction Z with the gap 63 therebetween. Adjusting inductance is performed, for example, by changing a distance between the barrel portions to change sizes of the gaps in the third direction Z. In the transformer 10 of Fig. 11, spacers are provided between the pair of first barrel portions 431 and 432, between the pair of second barrel portions 441 and 442, and between the pair of third barrel portions 451 and 452, respectively. The size of each of the gaps in the third direction Z can be adjusted by changing a size of the corresponding spacer. The spacer is constituted by an insulating sheet, for example.

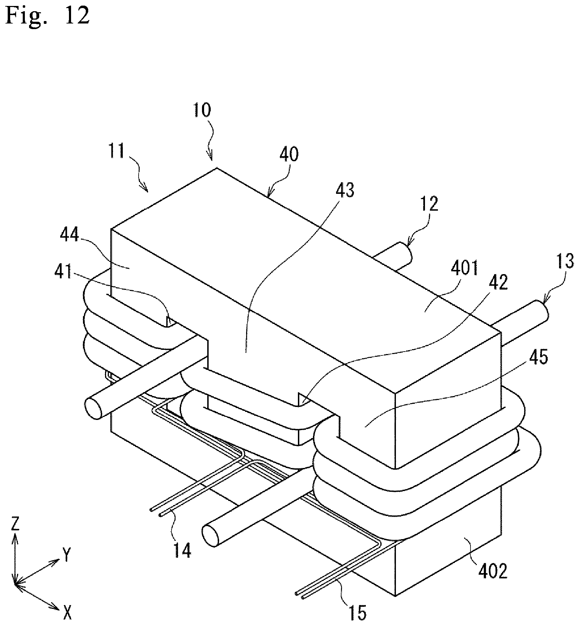

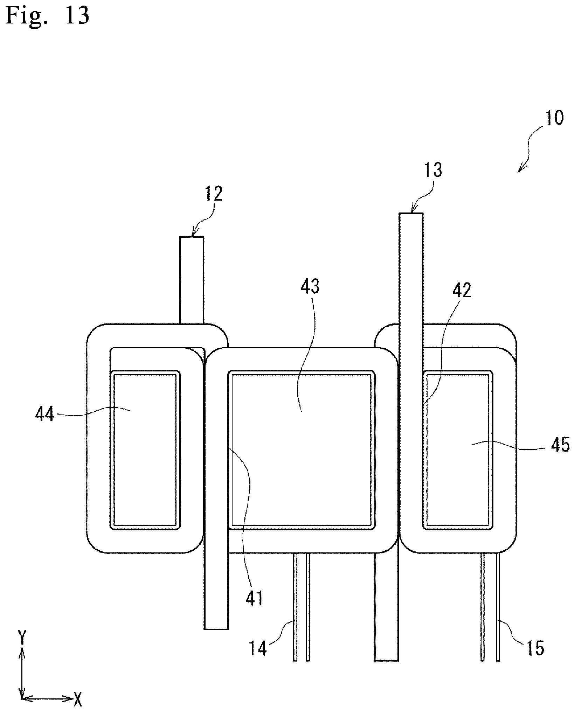

As illustrated in Figs. 12 and 13, the first main winding wire 12 may be wound around the first leg portion 43 and second leg portion 44, and the second main winding wire 13 may be wound around the first leg portion 43 and third leg portion 45. By increasing the numbers of turns of the first main winding wire 12 and the second main winding wire 13 with respect to the second leg portion 44 and the third leg portion 45, inductance with respect to the common mode noise current increases, and a function as a common mode choke that filters the common mode noise current is provided. The first detection winding wire 14 and the second detection winding wire 15 are adjusted to obtain desired detection gains as the first main winding wire 12 and the second main winding wire 13 increase. The function as the common mode choke can be used in combination with the function as the normal mode choke obtained by increasing the numbers of turns of the first main winding wire 12 and the second main winding wire 13 with respect to the first leg portion 43 (see Fig. 9). Fig. 13 shows the transformer 10 of Fig. 12 with the member 401 removed.

In the transformer 10 of Figs. 12 and 13, the absolute value of the voltage $V_{NM}$ detected by the first detection winding wire 14 is calculated by, for example, the following Formula 3, and the absolute value of the voltage $V_{CM}$ detected by the second detection winding wire 15 is calculated by, for example, the following Formula 4. In the following Formula 3, $n_1$ is the number of turns obtained by adding the number of turns of the first main winding wire 12 with respect to the second leg portion 44 or the number of turns of the second main winding wire 13 with respect to the third leg portion 45 to the total number of turns of the first main winding wire 12 and the second main winding wire 13 with respect to the first leg portion 43. In Figs. 12 and 13, n1 is $2\times1.5+3=6$. In the following Formula 4, $n_0$ is the number of turns of the first main winding wire 12 with respect to the second leg portion 44 or the number of turns of the second main winding wire 13 with respect to the third leg portion 45. In Figs. 12 and 13, $n_0$ is 3.

[Formula 3]

$$|V_{NM}| = \frac{n_1}{n_{NM}} i_{NM1} R_{NM}$$

[Formula 4]

$$|V_{CM}| = \frac{n_o + 1}{n_{CM}} i_{CM1} R_{CM}$$

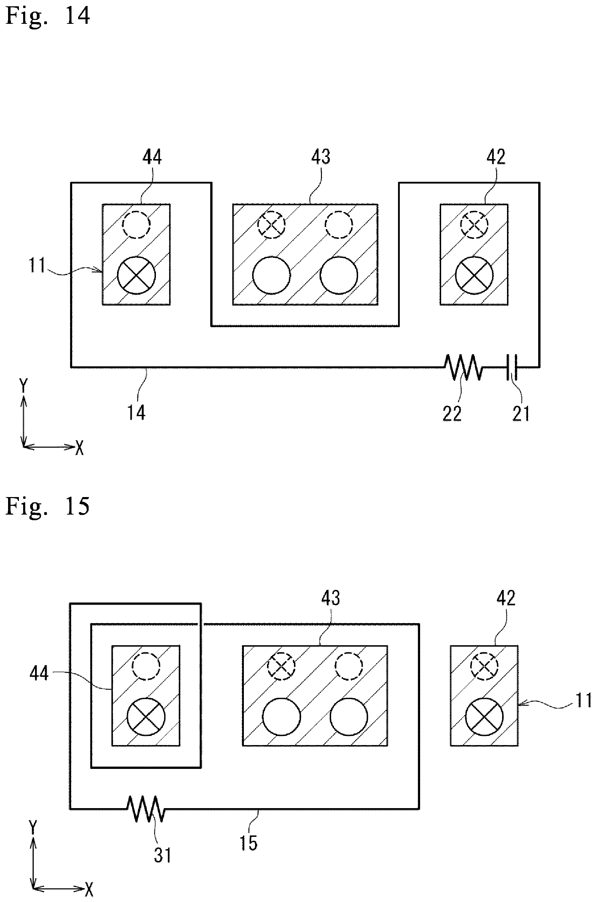

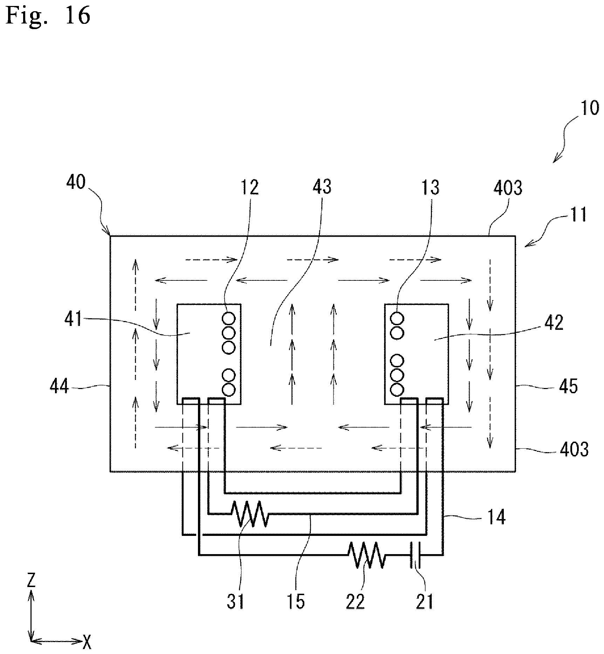

Fig. 14 illustrates another example of the winding method of the first detection winding wire 14, and Fig. 15 illustrates another example of the winding method of the second detection winding wire 15. As illustrated in Fig. 16, each of the first detection winding wire 14 and the second detection winding wire 15 may be wound around a portion around which the first main winding wire 12 and the second main winding wire 13 are not wound. In the transformer 10 of Fig. 16, a substantially rectangular plate-shaped plate portion 403 is positioned at each of both ends of the three leg portions in the third direction Z. The first detection winding wire 14 and the second detection winding wire 15 are wound around one plate portion 403. The plate portion 403 extends along the first direction X, and is connected to one end of the first leg portion 43 in the third direction Z, one end of the second leg portion 44 in the third direction Z, and one end of the third leg portion 45 in the third direction Z. In Fig. 16, the direction of the magnetic flux by the normal mode noise current is indicated by a solid arrow, and the direction of the magnetic flux by the common mode noise current is indicated by a dotted arrow. As described above, the first detection winding wire 14 may take any configuration in which the first detection winding wire 14 is wound around the iron core 11 in a state in which the magnetic flux generated by the common mode noise current flowing through the first main winding wire 12 and the second main winding wire 13 is cancelable, and the normal mode noise current can be detected. Further, the second detection winding wire 15 may take any configuration in which the second detection winding wire 15 is wound around the iron core 11 in a state where the magnetic flux generated by the normal mode noise current flowing through the first main winding wire 12 and the second main winding wire 13 is cancelable, and the common mode noise current can be detected. As a result, it is possible to increase a degree of freedom in designing the transformer 10, and therefore the transformer 10 capable of more reliably downsizing the power supply circuit can be realized.

The iron core main body 40 may take any configuration in which the first through hole 41, the second through hole 42, and the first leg portion 43 positioned between the first through hole 41 and the second through hole 42 are included. For example, the iron core main body 40 may be constituted by a single member. The two members 401 and 402 constituting the iron core main body 40 are not limited to the case where both members are substantially E-shaped when viewed along the second direction Y, and one of the members may be substantially I-shaped.

The transformer 10 may include a bobbin that covers the iron core 11. By including the bobbin, for example, each of the first main winding wire 12 and the second main winding wire 13 can be positioned with respect to the first leg portion 43 and held.

The normal mode active filter 20 may take any configuration with which the normal mode noise current can be reduced. Similarly, the common mode active filter 30 may take any configuration with which the common mode noise current can be reduced.

Various embodiments of the present disclosure have been described above in detail with reference to the drawings, and finally, various aspects of the present disclosure will be described. In the following description, as an example, reference numerals are also added.

A transformer 10 according to a first aspect of the present disclosure includes:

an iron core 11 including an iron core main body 40 including a first through hole 41, a second through hole 42, and a first leg portion 43, the first through hole 41 and the second through hole 42 being positioned at intervals in a first direction and each penetrating the iron core main body 40 in a second direction that intersects the first direction, the first leg portion 43 being positioned between the first through hole 41 and the second through hole 42;
a first main winding wire 12 wound around the first leg portion 43 and including winding ends 121 and 122 positioned in the first through hole 41;
a second main winding wire 13 wound around the first leg portion 43 and including winding ends 131 and 132 positioned in the second through hole 42;
a first detection winding wire 14 wound around the iron core 11 in a state where a magnetic flux generated by a common mode noise current flowing through the first main winding wire 12 and the second main winding wire 13 is cancelable, the first detection winding wire 14 being configured to detect a normal mode noise current flowing through the first main winding wire 12 and the second main winding wire 13; and
a second detection winding wire 15 wound around the iron core 11 in a state where a magnetic flux generated by the normal mode noise current is cancelable, the second detection winding wire 15 being configured to detect the common mode noise current.

The transformer 10 according to a second aspect of the present disclosure is configured such that

the first leg portion 43 includes a gap 61 in a third direction that intersects the first direction and the second direction.

The transformer 10 according to a third aspect of the present disclosure is configured such that the iron core main body 40 includes:

a second leg portion 44 positioned on one side of the first leg portion 43 in the first direction, the first through hole 41 being positioned between the first leg portion 43 and the second leg portion 44; and a third leg portion 45 positioned on another side of the first leg portion 43 in the first direction, the second through hole 42 being positioned between the first leg portion 43 and the third leg portion 45, and the second leg portion 44 and the third leg portion 45 each include a gap 62 and 63 in a third direction that intersects the first direction and the second direction.

The transformer 10 according to a fourth aspect of the present disclosure is configured such that

the first main winding wire 12 is wound around each of the first leg portion 43 and the second leg portion 44, and the second main winding wire 13 is wound around each of the first leg portion 43 and the third leg portion 45.

The transformer 10 according to a fifth aspect of the present disclosure is configured such that each of the first detection winding wire 14 and the second detection winding wire 15 is wound around a portion around which the first main winding wire 12 and the second main winding wire 13 are unwound.

A noise filter device 1 according to a sixth aspect of the present disclosure includes the transformer 10 according to one of the above aspects.

By appropriately combining arbitrary embodiments or modified examples among the various embodiments or modified examples, it is possible to achieve the effects of the corresponding embodiments or modified examples. In addition, a combination of the embodiments, a combination of the examples, or a combination of the embodiment and the example are possible, and a combination of features in the different embodiments or examples are also possible.

Although the present disclosure has been fully described in connection with preferred embodiments with reference to the accompanying drawings, various changes and modifications will be apparent to those skilled in the art. It is understood that such changes and modifications are included within the scope of the present disclosure as set forth in the appended claims.

INDUSTRIAL APPLICABILITY

The transformer of the present disclosure can be applied to a noise filter device, for example.

The noise filter device of the present disclosure can be applied to, for example, a power system that operates as a power supply system that receives AC power and outputs DC power of about 2 kW.

EXPLANATION OF REFERENCES

| 1 | noise filter device |
|---|---|
| 2 | AC power source |
| 3 | noise source device |
| 10 | transformer |
| 11 | iron core |
| 12 | first main winding wire |
| 13 | second main winding wire |
| 14 | first detection winding wire |
| 15 | second detection winding wire |
| 20 | normal mode active filter |
| 21 | frequency removal filter |
| 22 | detection resistor |
| 23 | amplifier circuit |
| 24 | capacitor |
| 30 | common mode active filter |
| 31 | detection resistor |
| 32 | amplifier circuit |
| 33 | capacitor |
| 40 | iron core main body |
| 401, 402 | member |
| 403 | plate portion |
| 41 | first through hole |
| 42 | second through hole |
| 43 | first leg portion |
| 431, 432 | first barrel portion |
| 44 | second leg portion |
| 441, 442 | second barrel portion |
| 45 | third leg portion |
| 451, 452 | third barrel portion |
| 51 | normal mode noise current detection unit |
| 52 | common mode noise current detection unit |
| 61, 62, 63 | gap |
| 101, 102 | conductive line |

**Claims**

1. A transformer, comprising:

an iron core including an iron core main body including a first through hole, a second through hole, and a first leg portion, the first through hole and the second through hole being positioned at intervals in a first direction and each penetrating the iron core main body in a second direction that intersects the first direction, the first leg portion being positioned between the first through hole and the second through hole; a first main winding wire wound around the first leg portion and including winding ends positioned in the first through hole;

a second main winding wire wound around the first leg portion and including winding ends positioned in the second through hole;

a first detection winding wire wound around the iron core in a state where a magnetic flux generated by a common mode noise current flowing through the first main winding wire and the second main winding wire is cancelable, the first detection winding wire being configured to detect a normal mode noise current flowing through the first main winding wire and the second main winding wire; and

a second detection winding wire wound around the iron core in a state where a magnetic flux generated by the normal mode noise current is cancelable, the second detection winding wire being configured to detect the common mode noise current.

2. The transformer according to claim 1, wherein the first leg portion includes a gap in a third direction that intersects the first direction and the second direction.

3. The transformer according to claim 1 or 2, wherein the iron core main body includes:

a second leg portion positioned on one side of the first leg portion in the first direction, the first through hole being positioned between the first leg portion and the second leg portion; and
a third leg portion positioned on another side of the first leg portion in the first direction, the second through hole being positioned between the first leg portion and the third leg portion, and the second leg portion and the third leg portion each include a gap in a third direction that intersects the first direction and the second direction.

4. The transformer according to claim 3, wherein

the first main winding wire is wound around each of the first leg portion and the second leg portion, and
the second main winding wire is wound around each of the first leg portion and the third leg portion.

5. The transformer according to any one of claims 1 to 4, wherein
each of the first detection winding wire and the second detection winding wire is wound around a portion around which the first main winding wire and the second main winding wire are unwound.

6. A noise filter device, comprising:

the transformer according to any one of claims 1 to 5.

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

## INTERNATIONAL SEARCH REPORT

| International application No. |
|---|
| **PCT/JP2023/003603** |

### A. CLASSIFICATION OF SUBJECT MATTER

*H01F 30/10*(2006.01)i; *H01F 27/24*(2006.01)i; *H01F 27/28*(2006.01)i; *H01F 27/34*(2006.01)i
FI:  H01F30/10 C; H01F30/10 A; H01F27/28 K; H01F27/24 W; H01F27/34

According to International Patent Classification (IPC) or to both national classification and IPC

### B. FIELDS SEARCHED

Minimum documentation searched (classification system followed by classification symbols)

H01F30/10; H01F27/24; H01F27/28; H01F27/34

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 10-163046 A (MATSUSHITA ELECTRIC IND CO LTD) 19 June 1998 (1998-06-19) | 1-6 |
| A | US 2019/0096571 A1 (UNIVERSITY OF FLORIDA RESEARCH FOUNDATION, INCORPORATED) 28 March 2019 (2019-03-28) | 1-6 |
| A | JP 2007-184509 A (NEC TOKIN CORP) 19 July 2007 (2007-07-19) | 1-6 |

☐ Further documents are listed in the continuation of Box C.      ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **11 April 2023** | **25 April 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2023/003603**

| Patent document cited in search report | | | Publication date (day/month/year) | Patent family member(s) | Publication date (day/month/year) |
|---|---|---|---|---|---|
| JP | 10-163046 | A | 19 June 1998 | (Family: none) | |
| US | 2019/0096571 | A1 | 28 March 2019 | (Family: none) | |
| JP | 2007-184509 | A | 19 July 2007 | (Family: none) | |

Form PCT/ISA/210 (patent family annex) (January 2015)

**REFERENCES CITED IN THE DESCRIPTION**

**Patent documents cited in the description**

- JP 2022018792 A